# EUROPÄISCHE PATENTSCHRIFT

(11) **EP 3 862 759 B1**
(45) Veröffentlichungstag und Bekanntmachung des Hinweises auf die Patenterteilung: **11.05.2022**
(21) Anmeldenummer: 20155340.1
(22) Anmeldetag: 04.02.2020
(51) Int. Cl.: G01R 1/067, G01R 1/073, G01R 3/00

(54) **MANTELDRAHT UND VERFAHREN ZUR HERSTELLUNG VON MANTELDRÄHTEN**
SHEATHED WIRE AND METHOD FOR PRODUCING SAME
FIL ENROBE ET PROCÉDÉ DE FABRICATION DE FIL ENROBE

(43) Veröffentlichungstag der Anmeldung: 11.08.2021
(73) Patentinhaber: Heraeus Deutschland GmbH & Co. KG, 63450 Hanau (DE)
(72) Erfinder: RÄTTIG, Marc, 63450 Hanau (DE); BIRNBAUM, Thilo, 63450 Hanau (DE)
(74) Vertreter: Schultheiss & Sterzel Patentanwälte PartG mbB

(56) Entgegenhaltungen:
- EP-A1- 2 060 921
- DE-T2- 69 635 227
- US-A1- 2012 071 037
- US-A1- 2016 252 547
- US-A1- 2017 122 980

## Beschreibung

Die Erfindung betrifft einen Manteldraht zur Herstellung von Prüfnadeln zur Prüfung der Kontaktierung von Anschlusspads oder zur Herstellung von Schleifkontakten wie Vieldrahtschleifer und Büschelbürsten.

Die Erfindung betrifft auch eine Prüfnadel und einen Schleifkontakt aufweisend zumindest einen solchen Manteldraht und ein Verfahren zur Herstellung eines solchen Manteldrahts.

Manteldrähte kombinieren die Eigenschaften unterschiedlicher Materialien und können daher in unterschiedlichen Bereichen nutzbringend eingesetzt werden. Beispielsweise können Manteldrähte als Prüfnadeln zur Prüfung der Kontaktierung von Anschlüssen in der Mikroelektronik oder als Schleifdrähte zur Herstellung von Schleifkontakten eingesetzt werden.

Während der Chipproduktion werden Wafer direkt nach der Prozessierung mit Prüfnadeln kontaktiert, um die Funktionsfähigkeit der integrierten Schaltungen (IC) in ungesägtem Zustand zu testen. Ein Array von Prüfnadeln testet dabei nach der Strukturierung der einzelnen Chips den Halbleiterwafer auf Funktionalität. Die Prüfnadeln sind in einer Testkarte (probe card) fixiert, die auf das Design des Wafers abgestimmt ist. Beim Prüfprozess wird der Wafer auf die Prüfnadeln gepresst und eine Kontaktierung zwischen Prüfnadeln und den Pads der ICs hergestellt, bei Aluminium Pads durch eine Passivierungsschicht hindurch hergestellt. Daraufhin werden verschiedene Parameter getestet, wie zum Beispiel die Kontaktierung, elektrische Kennwerte bei hoher Stromdichte und das elektrische Verhalten bei Temperaturwechseln.

Prüfnadeln werden also bei der Herstellung von Leistungselektronik, der Kontaktierung von Chips und anderen elektrischen Schaltungen zur Prüfung der Qualität von elektrischen Kontaktierungen eingesetzt (siehe hierzu beispielsweise die US 2014/0266278 A1 und die US 2010/0194415 A1).

Die US 2016/252547 A1 offenbart eine Prüfnadel mit einem elektrisch leitenden Kernelement, das aus einer Metalllegierung besteht, und einem elektrisch isolierenden Gehäuseelement, das das Kernelement umgibt. Das Kernelement besteht aus einer Metalllegierung auf Rhodiumbasis.

Die Schlüsselparamater einer guten Prüfnadel sind eine hohe elektrische Leitfähigkeit, da hierbei hohe elektrische Ströme übertragen werden müssen, sowie ein passendes E-Modul (m_{E}) und eine hohe Streckgrenze (Rp_{0,2}), welche gute Federeigenschaften hervorrufen. Eine hohe thermische Leitfähigkeit bewirkt eine gute Abfuhr der Wärmeenergie und damit eine möglichst geringe zusätzliche thermische Erhöhung des elektrischen Widerstands. Geeignete Härte, E-Modul und Streckgrenze werden benötigt, um zum einen die Wartungsintervalle gering zu halten und zum anderen um gute Federeigenschaften der Prüfnadel zu realisieren.

Für das Testen auf Aluminiumpads sind Prüfnadeln aus den Materialien Wolfram, Wolframcarbid, Palladium-Kupfer-Silber-Legierungen und Wolfram-Rhenium weit verbreitet. Diese sind besonders hart, wobei Aluminiumpads robuster als Goldpads sind und einer Prüfung mit harten Nadeln besser standhalten können als Goldpads.

Für die Anwendung auf Goldpads sind Pd-Legierungen bekannt, wie beispielsweise Paliney^{®} H3C der Firma Deringer Ney oder NewTec^{®} der Firma Advanced Probing. Weiterhin existieren PtNi30-Legierungen für Prüfnadeln im Markt. Aus der US 2010/0239453 A1 und der EP 2 248 920 A1 sind niedrig dotierte Iridium-Legierungen zur Herstellung von Prüfnadeln bekannt.

Die US 2006/0197542 A1 offenbart eine Iridium-Basislegierung und eine Platin-Basislegierung zum Herstellen von Prüfnadeln. Die Legierungen weisen eine hohe Härte zwischen 300 HV und 500 HV auf, um einen guten Kontakt durch eine auf den Goldpads angeordnete Lackschicht herstellen zu können.

Iridium hat den Nachteil, dass es eine geringere Wärmeleitfähigkeit und elektrische Leitfähigkeit als andere Metalle hat.

Nachteilig ist bei diesen Legierungen auch, dass die Spitzen angeschliffen werden müssen, was ein teurer und häufig manuell durchgeführter Prozess ist.

Weiterhin können Prüfstrukturen in geringem Umfang mikrosystemtechnisch hergestellt werden. Nachteilig sind dabei die hohen Herstellungskosten.

Aktuell werden für sogenannte "Probe Needles" (Prüfnadeln) Metalle oder Legierungen verwendet, die eine hohe elektrische und thermische Leitfähigkeit aber auch hohe Härten und Zugfestigkeiten besitzen. Dabei dient die elektrische Leitfähigkeit von reinem Kuper (100% IACS) als Referenz. Kupfer (Cu) und Silber (Ag) können zu diesen Zwecken jedoch nicht eingesetzt werden, da sie deutlich zu duktil sind und sich die Prüfnadel beim Einsatz verformen würde. Typische Materialien für Prüfnadeln sind ausscheidungsgehärtete Palladium-Silber-Legierungen, die 10% Gold und 10% Platin enthalten und beispielsweise unter den Produktnamen Paliney^{®} 7 und Hera 648 vertrieben werden. Als Materialien für Folien zur Herstellung von Prüfnadeln werden aber auch PtNi-Legierungen (Platin-Nickel-Legierungen) oder Rhodium (Rh) verwendet. Bei solchen Metallen oder Legierungen, die einen möglichst guten Kompromiss zwischen elektrischer Leitfähigkeit, thermischer Leitfähigkeit, Zugfestigkeit sowie Härte darstellen, beträgt die maximal mögliche elektrische Leitfähigkeit 5% bis 30% IACS.

Typische Materialien für Probing-Anwendungen sind unter anderem Rhodium und seine Legierungen. Da Rhodium in reiner Form ein verhältnismäßig hohes E-Modul hat (ca. 370 GPa), ist es jedoch nur bedingt einsetzbar. Diese Einschränkung bewirkt, dass Prüfnadeln aus diesen Materialien nur mit dünnsten Durchmessern und extrem verlängerte Prüfnadeln verwendbar sind, um das E-Modul beziehungsweise die daraus folgende notwendige mechanische Kraft und Spannung zu kompensieren. Die längere Nadel hat jedoch zur Folge, dass der elektrische Widerstand der Prüfnadel stark steigt, was unvorteilhaft ist. Gleichzeitig haben Rhodium und seine Legierungen üblicherweise ohnehin nur geringe elektrische Leitfähigkeiten von nur etwa 30% IACS. Ferner wird die Wärmeableitung durch eine dünne und lange Prüfnadel verschlechtert.

Neben Prüfnadeln profitieren aber auch andere Anwendungen, wie insbesondere Drähte für Schleifkontakte, von Materialien mit hohen elektrischen und thermischen Leitfähigkeiten und gleichzeitig guten mechanischen Eigenschaften, wie einer hohen Härte und Zugfestigkeit. Bei Schleifkontakten ist es wichtig, dass einerseits durch die Oberflächen ein geringer Übergangswiderstand verursacht wird und andererseits das Material sich nicht zu schnell abnutzt also abreibt oder erodiert.

Anwendungen wie Prüfnadeln (Probe Needles) oder Schleifdrähte in der Leistungselektronik erfordern neben einer hohen elektrischen Leitfähigkeit auch eine hohe mechanische Festigkeit und Härte. Dabei ist auch die Temperaturbeständigkeit beziehungsweise die Warmfestigkeit von entscheidender Bedeutung.

Die WO 2016/009293 A1 schlägt eine Prüfnadel vor, wobei an der Vorderseite der Prüfnadel eine Spitze angeordnet ist, die aus einem mechanisch harten ersten Material besteht und der Rest der Prüfnadel aus einem zweiten Material mit einer hohen elektrischen Leitfähigkeit besteht. Ähnliche Prüfnadeln sind auch aus der US 2013/0099813 A1, der EP 2 060 921 A1 und der US 2012/0286816 A1 bekannt. Mit der US 2019/0101569 A1 wird ein Manteldraht mit einer solchen Spitze vorgeschlagen, wobei die Spitze nur an der Drahtseele des Manteldrahts befestigt wird. Der Manteldraht soll dabei eine Drahtseele mit einer einzelnen Beschichtung aufweisen. Nachteilig ist hieran, dass die Prüfnadel über ihre Länge keine homogenen physikalischen Eigenschaften mehr hat und dass die elektrische und thermische Leitfähigkeit aber auch die Zugfestigkeit sehr stark von der Verbindung zwischen den beiden Materialien abhängt. Zudem lässt sich eine niedrige elektrische Leitfähigkeit in einem Bereich nicht einfach durch eine hohe elektrische Leitfähigkeit in einem anderen Bereich ausgleichen, da der Strom wie bei Reihenschaltungen von elektrischen Widerständen beide Bereiche passieren muss.

Als Verbunddrähte zur Herstellung von Prüfnadeln oder Schleifdrähten können beispielsweise rundumbeschichtete Drähte eingesetzt werden, die als sogenannte Manteldrähte oder Double-Drähte durch endlos Walzprozesse oder mit Hilfe von galvanischen Beschichtungen hergestellt werden können. Beispielsweise können diese im Inneren ein Unedel-Metall, beispielsweise aus einer Cu-Legierung wie CuBe₂ aufweisen, ummantelt mit einer Edelmetall- Legierung (beispielsweise Hera238), um für kontakttechnische Anwendungen bei gleitenden Kontakten in Schleifringübertragern oder auch Schaltkontakten in Mikroschaltern eingesetzt werden zu können, so wie dies in der nicht vorveröffentlichten DE 10 2019 130 522.5 beschrieben ist.

Die Aufgabe der Erfindung besteht also darin, die Nachteile des Stands der Technik zu überwinden. Insbesondere sollen Materialien und ein Verfahren zur Herstellung solcher Materialien gefunden werden, aus denen Prüfnadeln herstellbar sind, die eine größere Wärmeleitfähigkeit und elektrische Leitfähigkeit aufweisen und gleichzeitig die für Prüfnadeln geeigneten mechanischen Eigenschaften bezüglich des E-Moduls und der Federeigenschaften aufweisen.

Ferner sollen die Materialien eine ausreichend hohe Härte aufweisen, um möglichst eine lange Standzeit und nur eine geringe oder keine Beschädigungen von den Pads zu garantieren. Gleichzeitig sollen die Materialien eine ausreichende Elastizität besitzen, damit sich die Prüfnadeln nicht bei der Kontaktierung plastisch verformen und um die Toleranzen beim Herstellen von Testkarten mit solchen Prüfnadeln möglichst groß zu halten.

Eine weitere Aufgabe der Erfindung liegt darin eine Prüfnadel bereitzustellen, die die zuvor genannten Eigenschaften erfüllt. Ferner ist eine weitere Aufgabe in der Entwicklung eines Schleifkontakts aufweisend mehrere Drähte aus einem solchen Material zu sehen.

Die Aufgabe der Erfindung wird gelöst, durch einen Manteldraht zur Herstellung von Prüfnadeln oder Schleifkontakten aufweisend
1. eine Drahtseele aus Rhodium oder einer Rhodium-Basis-Legierung,
2. einen inneren Mantel aus Aluminium oder Kupfer oder Silber oder einer Kupfer-Basis-Legierung oder einer Silber-Basis-Legierung oder einer Aluminium-Basis-Legierung, wobei der innere Mantel die Drahtseele an zumindest zwei gegenüberliegenden Seiten bedeckt oder vollständig umschließt,
3. eine Haftvermittlungsschicht aus Gold oder einer Gold-Basis-Legierung, die zwischen der Drahtseele und dem inneren Mantel angeordnet ist, und
4. einen äußeren Mantel aus einem Metall oder einer Metalllegierung mit einer größeren Härte als das Material des inneren Mantels, wobei der äußere Mantel den inneren Mantel umschließt.

Unter einer Basis-Legierung wird eine Legierung verstanden, bei der die Legierung an Anteil von zumindest 50 at% des angegebenen Elements enthält.

Unter einem Mantel wird eine Schicht oder eine Beschichtung verstanden, die einen weiter innen liegenden Teil des Manteldrahts umgibt.

Es kann vorgesehen sein, dass der innere Mantel die Drahtseele vollständig umschließt und/oder dass der äußere Mantel den inneren Mantel vollständig umschließt.

Der äußere Mantel bildet vorzugsweise die äußere Oberfläche des Manteldrahts.

Unter einer Drahtseele wird der innerste, axial verlaufende Teil des Manteldrahts verstanden.

Als Rhodium-Basis-Legierung wird bevorzugt eine Rhodium-Legierung mit 0,01 Gew% bis 30 Gew% Zirkonium und maximal 1 Gew% anderen Elementen (Verunreinigungen) verwendet oder eine Rhodium-Legierung Hera5270. Besonders bevorzugt wird eine Legierung verwendet, wie sie in der EP 2 662 465 B1 beschrieben ist oder eine RhZr0,2-Legierung mit 0,2 Gew% Zirkonium und dem Rest Rhodium einschließlich herstellungsbedingter Verunreinigungen.

Die Gold-Basis-Legierung für die Haftvermittlungsschicht enthält vorzugsweise zumindest 90 at% Gold.

Die Kupfer-Basis-Legierung ist vorzugsweise eine Kupfer-Silber-Legierung oder eine Kupfer-Gold-Legierung oder eine Kupfer-Aluminium-Legierung mit wenigstens 50 at% Kupfer und üblichen Verunreinigungen oder eine Kupfer-Basis-Legierung enthaltend wenigstens 50 at% Kupfer und wenigstens zwei der Metalle Silber, Gold, Aluminium sowie übliche Verunreinigungen.

Die Silber-Basis-Legierung ist vorzugsweise eine Silber-Kupfer-Legierung oder eine Silber-Gold-Legierung oder eine Silber-Aluminium-Legierung mit wenigstens 50 at% Silber und üblichen Verunreinigungen oder eine Silber-Basis-Legierung enthaltend wenigstens 50 at% Silber und wenigstens zwei der Metalle Kupfer, Gold, Aluminium sowie übliche Verunreinigungen.

Es kann erfindungsgemäß bevorzugt vorgesehen sein, dass es sich bei dem Manteldraht um einen Mehrschichtverbunddraht handelt.

Besonders bevorzugt besteht die Drahtseele (bis auf übliche Verunreinigungen) aus einer Rhodium-Basis-Legierung mit 0,1 Gew% bis 30 Gew% Zirkonium (ganz besonders bevorzugt mit 0,2 Gew% Zirkonium), die Haftvermittlungsschicht aus Gold (bis auf übliche Verunreinigungen), der innere Mantel aus Kupfer, Silber oder Aluminium (bis auf übliche Verunreinigungen, wobei Kupfer ganz besonders bevorzugt ist) und der äußere Mantel aus einer Palladium-Nickel-Legierung, Rhodium, einer Rhodium-Zirkon-Legierung, einer Kupfer-Zinn-Zink-Legierung oder einer Gold-Basis-Legierung (bis auf übliche Verunreinigungen), wobei vorzugsweise die Gold-Basis-Legierung (bis auf übliche Verunreinigungen) eine Gold-Kobalt-Legierung, eine Gold-Eisen-Legierung oder eine Gold-Nickel-Legierung ist.

Bei erfindungsgemäßen Manteldrähten kann vorgesehen sein, dass das Volumen der Drahtseele zumindest genauso groß ist wie das Volumen des inneren Mantels, bevorzugt das Volumen der Drahtseele genauso groß ist wie das Volumen des inneren Mantels oder bis zu 20-mal größer ist wie das Volumen des inneren Mantels.

Bei erfindungsgemäßen Manteldrähten kann auch vorgesehen sein, dass die Drahtseele und der innere Mantel mindestens eine doppelt so große Dicke beziehungsweise Schichtstärke aufweisen wie die Haftvermittlungsschicht, insbesondere eine mindestens dreimal so große Dicke beziehungsweise Schichtstärke aufweisen wie die Haftvermittlungsschicht.

Durch diese beiden Maßnahmen wird erreicht, dass die wesentlichen mechanischen und die elektrischen Eigenschaften des Manteldrahts vor allem durch die Drahtseele und den inneren Mantel sowie deren Volumenverhältnis bestimmt werden.

Des Weiteren kann vorgesehen sein, dass zwischen dem inneren Mantel und dem äußeren Mantel eine Diffusionsschutzschicht als Diffusionsbarriere angeordnet ist, wobei vorzugsweise die Diffusionsschutzschicht aus Nickel oder Gold oder einer Nickel-Basis-Legierung oder einer Gold-Basis-Legierung besteht.

Hierdurch wird erreicht, dass insbesondere die elektrischen Eigenschaften des inneren Mantels nicht durch Eindiffundieren von Atomen oder Ionen aus dem äußeren Mantel beeinträchtigt werden. Insbesondere soll die elektrische Leitfähigkeit des inneren Mantels hierdurch nicht reduziert werden. Insbesondere wird hierdurch eine Verschlechterung der elektrischen Leitfähigkeit im Laufe der Zeit bei Verwendung des Manteldrahts durch Eindiffundieren von Fremdatomen in den inneren Mantel vermieden.

Dabei kann vorgesehen sein, dass der innere Mantel mindestens eine doppelt so große Schichtstärke aufweist wie die Diffusionsschutzschicht, bevorzugt der innere Mantel mindestens eine dreimal so große Schichtstärke aufweist wie die Diffusionsschutzschicht.

Damit soll sichergestellt werden, dass die Diffusionsschutzschicht nicht die mechanischen Eigenschaften und elektrischen Eigenschaften des Manteldrahts selbst zu stark beeinflusst im Vergleich zum inneren Mantel.

Gemäß einer bevorzugten Weiterbildung der vorliegenden Erfindung kann vorgesehen sein, dass der äußere Mantel aus Rhodium, einer Rhodium-Basis-Legierung, einer Kupfer-Zinn-Zink-Legierung, einer Palladium-Nickel-Legierung oder einer Gold-Basis-Legierung besteht, wobei vorzugsweise die Gold-Basis-Legierung eine Gold-Kobalt-Legierung, eine Gold-Eisen-Legierung oder eine Gold-Nickel-Legierung ist.

Diese Materialien und Legierungen sind hart und so besonders gut als abrasive Schutzschichten verwendbar. Bevorzugt ist, dass der äußere Mantel aus einer Palladium-Nickel-Legierung besteht.

Auch kann vorgesehen sein, dass der Manteldraht bei Raumtemperatur ein Elastizitätsmodul (E-Modul oder kurz m_{E}) von mindestens 150 GPa aufweist, bevorzugt von mindestens 200 GPa aufweist, besonders bevorzugt von 215 GPa aufweist, und/oder
der Manteldraht bei Raumtemperatur eine 0,2%-Dehngrenze Rp_{0,2} (Elastizitätsgrenze) von mindestens 1800 MPa aufweist, bevorzugt von mindestens 2000 MPa aufweist, besonders bevorzugt von 2150 MPa aufweist, und/oder
der Manteldraht bei Raumtemperatur eine elektrische Leitfähigkeit von mindestens 40% IACS aufweist, bevorzugt von mindestens 50% IACS aufweist, besonders bevorzugt von 57% IACS aufweist

Durch diese mechanischen und elektrischen Eigenschaften und insbesondere durch deren Kombination wird sichergestellt, dass der Manteldraht besonders gute elastische Eigenschaften und eine hohe elektrische Leitfähigkeit hat, um diesen als Prüfnadel oder Schleifkontakt einsetzen zu können.

Das E-Modul m_{E}, die 0,2%-Dehngrenze Rp_{0,2} und die Zugfestigkeit Rₘ werden mit einer Zwick Zugprüfmaschine Z250 bestimmt. Der Zugversuch erfolgte an einem Manteldraht mit 55 µm Drahtdurchmesser und beziehen sich hierauf. Die Prüfgeschwindigkeit bezüglich des E-Moduls m_{E} und der Streckgrenze Rp_{0,2} war 1mm/min, während die Prüfgeschwindigkeit für die Zugfestigkeit Rₘ bei 10mm/min lag.

Die elektrische Leitfähigkeit wurde mit einer 4-Pol Messung des Spannungsabfalles am Prüfling bei definierter Länge mit einem Burster Resistomat 2316 bestimmt. Die Messung erfolgt einem Manteldraht mit einer Drahtlänge zwischen 0,06 m und 0,07 m, einem Durchmesser von 52 µm und einem Messstrom von 10 mA.

Ferner kann vorgesehen sein, dass der Manteldraht einen Durchmesser oder eine Dicke von maximal 200 µm aufweist, bevorzugt einen Durchmesser oder eine Dicke zwischen 10 µm und 100 µm aufweist, ganz besonders bevorzugt einen Durchmesser oder eine Dicke zwischen 20 µm und 70 µm aufweist.

Manteldrähte mit diesen Durchmessern beziehungsweise flache Manteldrähte mit diesen Dicken sind besonders gut als Prüfnadeln und als Schleifdrähte einsetzbar.

Des Weiteren kann vorgesehen sein, dass die Drahtseele einen Durchmesser oder eine Dicke zwischen 9 µm und 100 µm aufweist, bevorzugt zwischen 20 µm und 70 µm aufweist, ganz besonders bevorzugt einen Durchmesser oder eine Dicke zwischen 30 µm und 60 µm aufweist, und/oder
der innere Mantel eine Schichtstärke zwischen 1 µm und 20 µm aufweist, bevorzugt zwischen 5 µm und 15 µm aufweist, und/oder
der äußere Mantel eine Schichtstärke zwischen 0,5 µm und 5 µm aufweist, bevorzugt zwischen 1 µm und 3 µm aufweist, und/oder
die Haftvermittlungsschicht eine Schichtstärke zwischen 100 nm und 1000 nm aufweist, bevorzugt zwischen 300 nm und 600 nm aufweist.

Mit diesem Materialstärken wird erreicht, dass die Drahtseele und die jeweiligen Schichten die gewünschten Beiträge zu den mechanischen und elektrischen Eigenschaften des Manteldrahts leisten.

Es kann auch vorgesehen sein, dass die Haftvermittlungsschicht, der innere Mantel, der äußere Mantel und gegebenenfalls die Diffusionsschutzschicht galvanische Beschichtungen sind.

Hiermit wird eine kostengünstige Beschichtung ermöglicht. Zudem kann auf diese Weise sichergestellt werden, dass eine vollumfängliche Beschichtung erfolgt.

Wenn der innere Mantel aus Aluminium oder einer Aluminium-Basis-Legierung besteht, kann dieser vorzugsweise mit einem physikalischen Aufdampfverfahren wie physikalischer Gasphasenabscheidung (PVD - "Physical Vapor Deposition") auf die Drahtseele aufgetragen werden.

Gemäß einer bevorzugten Ausführung kann vorgesehen sein, dass die Drahtseele kaltverfestigt ist.

Unter einem kaltverfestigten Material wird ein Material verstanden, das durch mechanisches Umformen gegen weitere Verformungen verfestigt wurde. Da sich durch eine plastische Verformung die Versetzungsdichte erhöht (auf bis zu 10¹² m⁻²), steigt die Wahrscheinlichkeit, dass sich Versetzungen bei ihrer Bewegung gegenseitig behindern. Entsprechend ist zur Weiterverformung eine größere Spannung notwendig, was sich in einer Zunahme von Dehngrenze und Festigkeit bemerkbar macht. Man bezeichnet dieses Verhalten als Kaltverfestigung. Dieser Effekt wird erfindungsgemäß genutzt, um die Festigkeit der Drahtseele durch geringe Vorverformung z. B. durch Walzen oder Ziehen zu erhöhen.

Hiermit werden die mechanischen Eigenschaften, insbesondere die Federeigenschaften des Manteldrahts verbessert.

Ferner kann vorgesehen sein, dass die Drahtseele einen rechteckigen Querschnitt aufweist. Bevorzugt kann vorgesehen sein, dass der Manteldraht aus einem Band der Drahtseele hergestellt ist, besonders bevorzugt der Manteldraht aus einem mit dem inneren Mantel und der Haftvermittlungsschicht beschichteten Band der Drahtseele hergestellt ist.

Der Manteldraht kann also auch ein Manteldraht mit einem rechteckigen Querschnitt sein. Der Manteldraht kann dann als Flachdraht bezeichnet werden.

Alternativ kann die Drahtseele ein gewöhnlicher Draht mit einem runden, insbesondere kreisrunden, Querschnitt sein. Dann wird auch der Manteldraht einen runden, insbesondere reisrunden, Querschnitt aufweisen. Abweichungen von der idealen kreisrunden Symmetrie von bis zu 20% bezüglich des Durchmessers können insbesondere bei geringen Durchmessern von weniger als 80 µm auftreten.

Die bandförmige Drahtseele hat im Gegensatz zu einem Draht einen rechteckigen Querschnitt, wobei die Ecken abgerundet sein können. Bevorzugt ist die Breite der bandförmigen Drahtseele des Manteldrahts zumindest doppelt so groß wie die Dicke. Auch hier sind Abweichungen von bis zu 20% innerhalb des bandförmigen Manteldrahts möglich.

Die der vorliegenden Erfindung zugrundeliegenden Aufgaben werden auch gelöst durch ein Verfahren zur Herstellung eines Manteldrahts, gekennzeichnet durch die folgenden chronologischen Schritte
A) Bereitstellen einer Drahtseele aus Rhodium oder einer Rhodium-Basis-Legierung,
B) Beschichten der Drahtseele mit einer Haftvermittlungsschicht aus Gold oder einer Gold-Basis-Legierung,
C) Beschichten der mit der Haftvermittlungsschicht beschichteten Drahtseele mit einem inneren Mantel aus Kupfer oder Silber oder Aluminium oder einer Kupfer-Basis-Legierung oder einer Silber-Basis-Legierung oder einer Aluminium-Basis-Legierung, und
D) Beschichten der mit der Haftvermittlungsschicht und dem inneren Mantel beschichteten Drahtseele mit einem äußeren Mantel aus einem Metall oder einer Metalllegierung mit einer größeren Härte als das Material des inneren Mantels.

Der mit diesem Verfahren hergestellte Manteldraht hat die gleichen Vorteile wie der erfindungsgemäße Manteldraht.

Dabei kann bevorzugt vorgesehen sein, dass mit dem Verfahren ein erfindungsgemäßer Manteldraht hergestellt wird.

Bei erfindungsgemäßen Verfahren kann ferner vorgesehen sein, dass die Drahtseele bandförmig ist und zwischen Schritt C) und D) ein Schritt C1) erfolgt:
C1) Schneiden der beschichteten bandförmigen Drahtseele senkrecht zu einer Längsachse des Bands in eine Vielzahl von beschichteten Drahtseelen, bei denen die Drahtseelen an zwei gegenüberliegenden Seiten von der Haftvermittlungsschicht und dem inneren Mantel beschichtet sind, und
wobei in Schritt D) jede der beschichteten Drahtseelen mit dem äußeren Mantel beschichtet wird.

Hierdurch kann ein erfindungsgemäßer Manteldraht aus einer bandförmigen Drahtseele als Zwischenprodukt aufgebaut werden.

Bei erfindungsgemäßen Verfahren kann auch vorgesehen sein, dass zwischen Schritt C) und D) ein Schritt C2) erfolgt:
C2) Beschichten der mit der Haftvermittlungsschicht und dem inneren Mantel beschichteten Drahtseele mit einer Diffusionsschutzschicht, vorzugsweise mit einer Diffusionsschutzschicht aus Nickel oder Gold oder einer Nickel-Basis-Legierung oder einer Gold-Basis-Legierung, und wobei in Schritt D) das Beschichten des mit der Haftvermittlungsschicht, dem inneren Mantel und der Diffusionsschutzschicht beschichteten Drahtseele mit dem äußeren Mantel erfolgt.

Hierdurch wird erreicht, dass insbesondere die elektrischen Eigenschaften des inneren Mantels nicht durch Eindiffundieren von Atomen oder Ionen aus dem äußeren Mantel beeinträchtigt werden. Insbesondere soll die elektrische Leitfähigkeit des inneren Mantels hierdurch nicht reduziert werden.

Ferner kann vorgesehen sein, dass die Beschichtungen nach den Schritten B), C) und D) und gegebenenfalls C2) mit einem galvanischen Verfahren aufgebracht werden und/oder mit einem physikalischen Aufdampfverfahren, insbesondere mit physikalischer Gasphasenabscheidung (PVD), aufgebracht werden.

Hiermit wird eine kostengünstige Beschichtung ermöglicht. Zudem kann auf diese Weise sichergestellt werden, dass eine vollumfängliche Beschichtung erfolgt. Die Beschichtung mit Aluminium oder der Aluminium-Basis-Legierung erfolgt vorzugsweise mit physikalischer Gasphasenabscheidung (PVD). Alle anderen Beschichtungen erfolgen bevorzugt mit galvanischen Verfahren.

Es kann vorgesehen sein, dass die Drahtseele vor Schritt A) kaltverfestigt wird, bevorzugt durch mechanische Umformung kaltverfestigt wird, besonders bevorzugt durch Walzen und Ziehen kaltverfestigt wird.

Die der vorliegenden Erfindung zugrundeliegenden Aufgaben werden auch gelöst durch eine Prüfnadel aufweisend zumindest einen erfindungsgemäßen Manteldraht oder hergestellt aus einem Manteldraht, der mit einem erfindungsgemäßen Verfahren hergestellt wurde, wobei vorzugsweise die Prüfnadel senkrecht zur Zylinderachse des Manteldrahts oder senkrecht zu einer Längsachse des Manteldrahts gebogen ist.

Die der vorliegenden Erfindung zugrundeliegenden Aufgaben werden des Weiteren gelöst durch ein Prüfnadelarray aufweisend mehrere solche zueinander beabstandete Prüfnadeln.

Die der vorliegenden Erfindung zugrundeliegenden Aufgaben werden ferner gelöst durch Schleifkontakt aufweisend mehrere erfindungsgemäße Manteldrähte oder hergestellt aus einem Manteldraht, der mit einem erfindungsgemäßen Verfahren hergestellt wurde, wobei vorzugsweise die Manteldrähte ein Drahtbündel bilden.

Der Erfindung liegt die überraschende Erkenntnis zugrunde, dass es mit einem Manteldraht aus einer inneren Drahtseele aus Rhodium oder einer Rhodium-Basislegierung und einem hochleitfähigen inneren Mantel aus Kupfer oder Silber sowie einem harten äußeren Mantel gelingt, einen Manteldraht bereitzustellen, der die hohe elektrische Leitfähigkeit von Kupfer, Silber oder deren Basis-Legierungen aufweist und gleichzeitig die bevorzugten mechanische elastischen Eigenschaften durch die Drahtseele und den äußeren Mantel bereitstellt. Hierdurch ist der Manteldraht sowohl als Prüfnadel als auch zur Herstellung von Schleifkontakten gut einsetzbar.

Die Haftvermittlungsschicht dient dabei der stabileren Verbindung des inneren Mantels mit der Drahtseele bei elastischer Verformung des Manteldrahts. Dies bewirkt eine verbesserte Lebensdauer, indem ein lokales Ablösen des Materials des inneren Mantels von dem Material der Drahtseele infolge von Lastbiegewechseln verhindert wird.

Die gegebenenfalls vorhandene Diffusionsschutzschicht wird genutzt, um die elektrische Leitfähigkeit des inneren Mantels nicht zu beeinträchtigen. Es können auch mehrere Diffusionsbarrieren aus unterschiedlichen Materialien als Diffusionsschutzschicht genutzt werden. Auch hieraus ergibt sich eine verbesserte Lebensdauer, da ein ungewolltes Auflegieren des Materials des inneren Mantels verhindert wird, was eine Senkung der elektrischen Leitfähigkeit zur Folge hätte.

Das Material der Drahtseele ist besonders Zugfest, wenn RhZr0,2 oder eine andere Rhodium-Basis-Legierung enthaltend Zirkonium mit bis zu 30 at% Zirkonium verwendet wird (3000 MPa im Vergleich zu 1500 MPa bei reinem Rhodium) und lässt sich durch das Zirkonium besonders fein ziehen. Die hohe Zugfestigkeit erlaubt es verhältnismäßig dicke Kupferschichten oder Silberschichten als inneren Mantel aufzutragen, was eine starke Leitfähigkeitssteigerung zur Folge hat. Des Weiteren versprödet reines Rhodium bei etwa 100 µm bis 80 µm und bricht, weshalb heutige, marktübliche Nadeldurchmesser von ca. 50 µm aus reinem Rhodium nicht für diesen Zweck verwendbar sind.

Mit der vorliegenden Erfindung sind elektrische Leitfähigkeiten von ca. 60% IACS oder sogar mehr möglich. Des Weiteren verringert sich das resultierende Gesamt-E-Modul des Mehrschichtaufbaus deutlich, was eine starke Verbesserung der Federeigenschaften zur Folge hat, was sich in einer Vergrößerung des Quotienten Rp_{0,2} / m_{E} ausdrückt.

Mit der vorliegenden Erfindung wird ein Material bereitgestellt, das zum einen das Gesamt-E-Modul m_{E} des Manteldrahts, insbesondere des Mehrschichtverbunddrahts, drastisch senkt bei gleichzeitig hoher Streckgrenze Rp_{0,2} und zum anderen die elektrische Leitfähigkeit stark erhöht. Hierzu wird eine Drahtseele aus Rhodium und einer Rhodium-Legierung wie Hera5270 verwendet und diese mit diversen Funktionsschichten galvanisch beschichtet.

Um das weiche Kupfer beziehungsweise das weiche Silber verwenden zu können und somit deren hohe elektrische Leitfähigkeit für den Manteldraht nutzbar machen zu können, ist es wichtig, eine härtere Hüllschicht in Form des äußeren Mantels um den inneren Mantel herum anzuordnen.

Im Folgenden werden Ausführungsbeispiele der Erfindung anhand von zwölf Figuren erläutert, ohne jedoch dabei die Erfindung zu beschränken. Dabei zeigt:
Figur 1: eine schematische perspektivische Querschnittansicht auf einen erfindungsgemäßen Manteldraht;
Figur 2: eine Aufnahme eines Querschliffs durch einen erfindungsgemäßen Manteldraht mit einem Rasterelektronenmikroskop (REM);
Figur 3: eine weitere Aufnahme eines Querschliffs durch einen erfindungsgemäßen Manteldraht mit einem REM;
Figur 4: eine weitere Aufnahme eines Querschliffs durch einen erfindungsgemäßen Manteldraht mit einem REM;
Figur 5: eine weitere Aufnahme eines Querschliffs durch einen erfindungsgemäßen Manteldraht mit einem REM;
Figur 6: ein Kraft-Dehnungs-Diagramm eines erfindungsgemäßen Manteldrahts;
Figur 7: eine Aufnahme eines Querschliffs durch einen erfindungsgemäßen Manteldraht mit einem REM mit hoher Vergrößerung;
Figur 8: eine weitere Aufnahme eines Querschliffs durch einen erfindungsgemäßen Manteldraht mit einem REM mit hoher Vergrößerung;
Figur 9: eine Aufnahme eines Querschliffs durch einen erfindungsgemäßen Manteldraht mit einem REM mit hoher Vergrößerung sowie mit Krater von einer Härtemessung;
Figur 10: eine schematische perspektivische Querschnittansicht auf ein Zwischenprodukt zur Herstellung eines erfindungsgemäßen bandförmigen Manteldrahts aus einem beschichteten Band;
Figur 11: eine schematische perspektivische Querschnittansicht auf einen erfindungsgemäßen bandförmigen Manteldraht hergestellt aus dem Zwischenprodukt nach Figur 10; und
Figur 12: den Ablauf eines erfindungsgemäßen Verfahrens als Flussdiagramm.

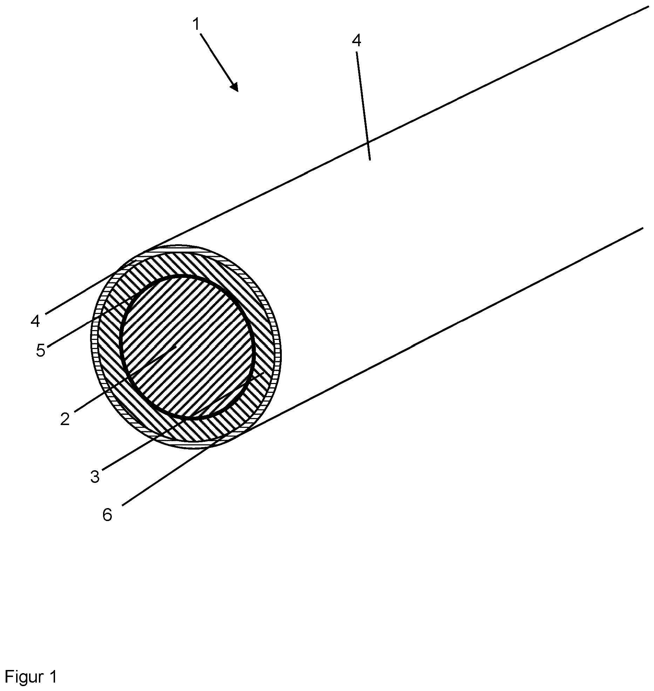

Figur 1 zeigt eine schematische perspektivische Querschnittansicht auf einen erfindungsgemäßen Manteldraht 1 mit einem zylindersymmetrischen Aufbau. Der Manteldraht 1 besteht aus einer Drahtseele 2 aus Rhodium oder einer Rhodium-Basis-Legierung, einem inneren Mantel 3 aus Kupfer oder Silber oder Aluminium oder einer Kupfer-Basis-Legierung oder einer Silber-Basis-Legierung oder einer Aluminium-Basis-Legierung, einem äußeren Mantel 4 aus einem Metall oder einer Metalllegierung und einer Haftvermittlungsschicht 5 aus Gold oder einer Gold-Basis-Legierung. Optional kann eine metallische Diffusionsschutzschicht 6 vorgesehen sein.

Die Drahtseele 2 verläuft im Innersten des Manteldrahts 1. Der innere Mantel 3 umschließt die Drahtseele 2. Der äußere Mantel 4 umschließt den inneren Mantel 3 und besteht aus einem Metall oder einer Metalllegierung mit einer größeren Härte als das Material des inneren Mantels 3, wie beispielsweise aus Rhodium, einer Rhodium-Basis-Legierung, einer Kupfer-Zinn-Zink-Legierung, einer Palladium-Nickel-Legierung oder einer Gold-Basis-Legierung besteht, wobei vorzugsweise die Gold-Basis-Legierung eine Gold-Kobalt-Legierung, eine Gold-Eisen-Legierung oder eine Gold-Nickel-Legierung ist. Die Haftvermittlungsschicht 5 ist zwischen der Drahtseele 2 und dem inneren Mantel 3 angeordnet. Die Diffusionsschutzschicht 6 kann zwischen dem inneren Mantel 3 und dem äußeren Mantel 4 angeordnet sein und die Migration von Atomen und Ionen aus dem äußeren Mantel 4 in den inneren Mantel 3 verhindern beziehungsweise erschweren, damit diese nicht die elektrische Leitfähigkeit des inneren Mantels 3 beeinträchtigen.

Die Drahtseele 2 kann einen Durchmesser von etwa 40 µm haben, der innere Mantel 3 kann eine Schichtstärke von etwa 10 µm haben und der äußere Mantel 4 kann eine Schichtstärke von etwa 2 µm haben. Die Haftvermittlungsschicht 5 und die Diffusionsschutzschicht 6 können dünner als 1 µm ausgebildet sein.

Zur Herstellung des Manteldrahts 1 kann zunächst die Drahtseele 2 aus einer Schmelze durch Erstarren und durch anschließendes Ziehen der Drahtseele 2 als Draht gewonnen werden. Die Drahtseele 2 wird vorzugsweise kaltverfestigt, um die mechanischen Eigenschaften der Drahtseele 2 zu verbessern. Die Oberfläche der Drahtseele 2 kann dann vor den folgenden Beschichtungsverfahren gereinigt werden. Die Drahtseele 2 kann aber auch mit einem anderen Verfahren hegestellt und zur weiteren Verarbeitung bereitgestellt werden.

Anschließend kann die Haftvermittlungsschicht 5 galvanisch auf die Drahtseele 2 aufgetragen werden. Danach kann der innere Mantel 3 galvanisch auf die mit der Haftvermittlungsschicht 5 beschichtete Drahtseele 2 aufgetragen werden. Anschließend kann dieser Aufbau galvanisch mit der Diffusionsschutzschicht 6 beschichtet werden. Als letztes kann der äußere Mantel 4 galvanisch auf die Diffusionsschutzschicht 6 oder direkt auf den inneren Mantel 3 aufgetragen werden.

Der so hergestellte Manteldraht 1 kann optional mit einer Wärmebehandlung nachbehandelt werden. Es ist möglich, den Manteldraht 1 als langen Endlosdraht (mindestens 10 m) auf einer Spule (nicht gezeigt) aufzuwickeln, um die spätere Verarbeitung zu vereinfachen. Aus dem Manteldraht 1 können kurze Stücke geschnitten werden, die dann als Bündel aneinandergefügt werden, um ein Drahtbündel als Schleifkontakt bereitzustellen. Alternativ können auch mehrere Drahtstücke des Manteldrahts 1 als Arrays beabstandet zueinander angeordnet werden, um Prüfnadelarrays zu formen.

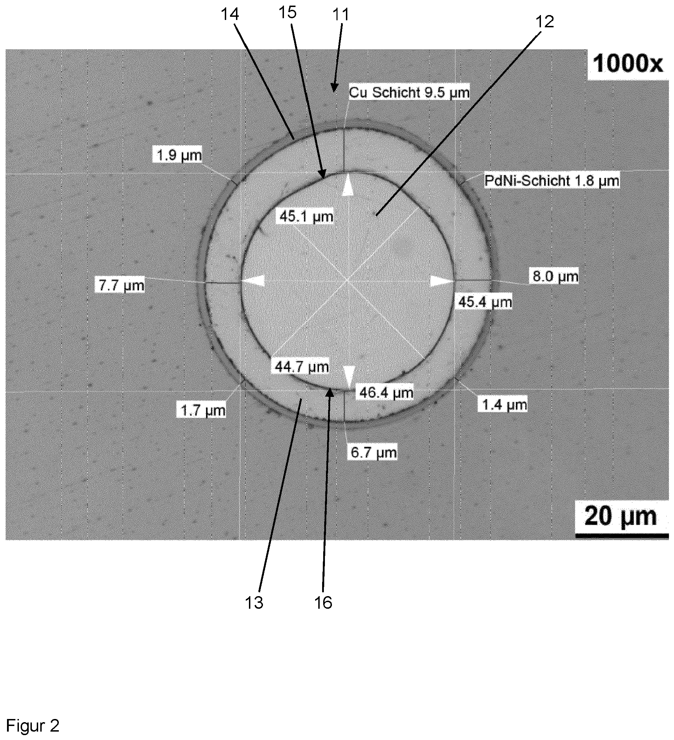

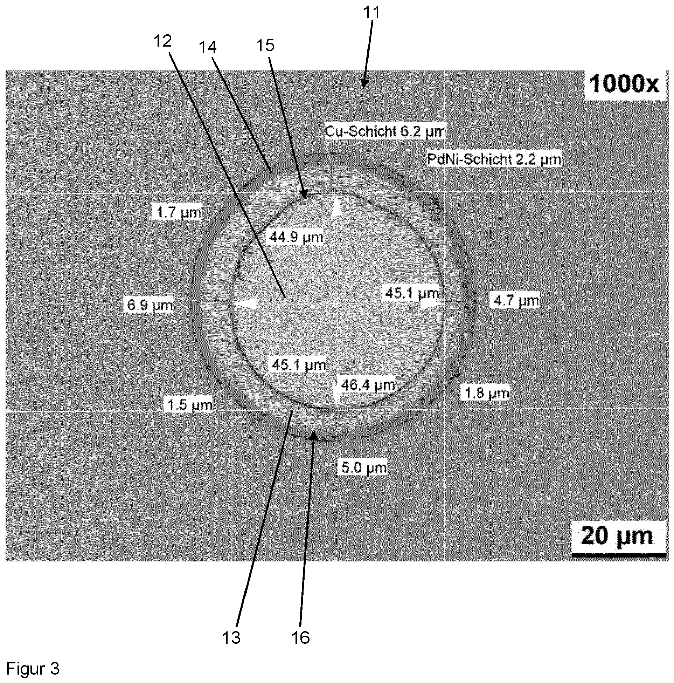

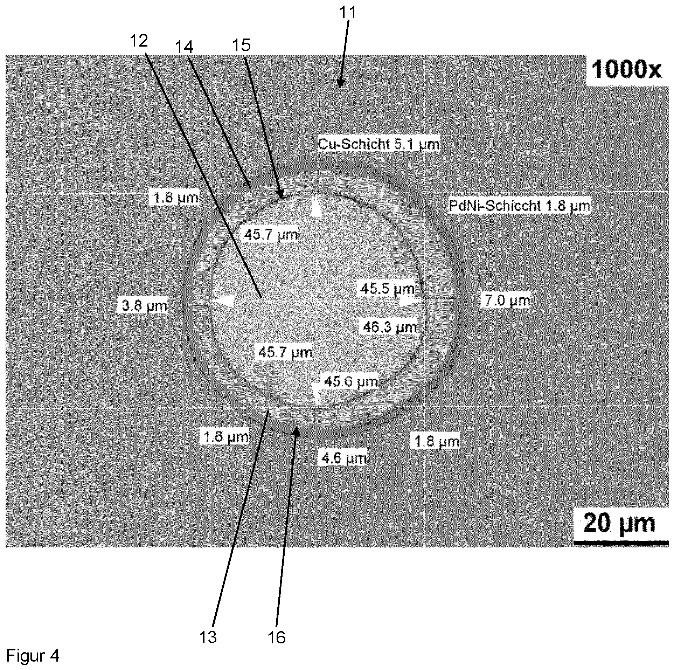

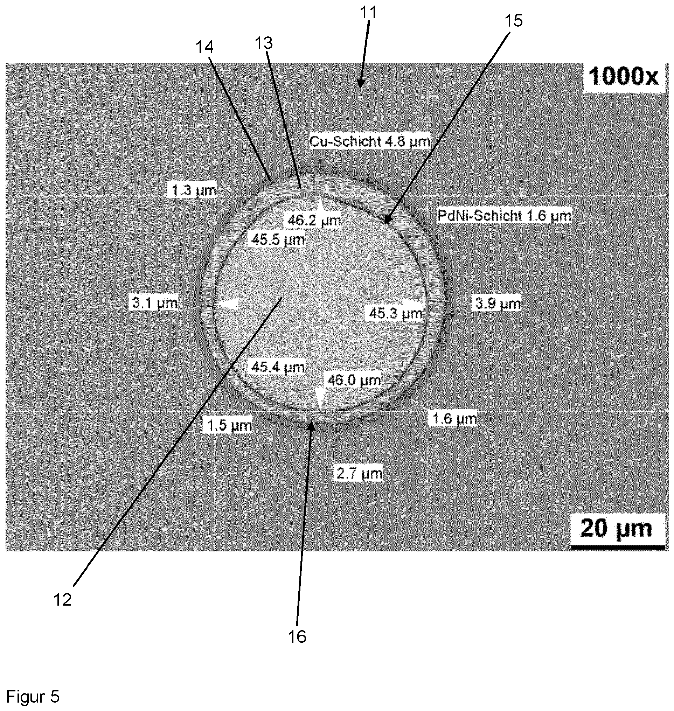

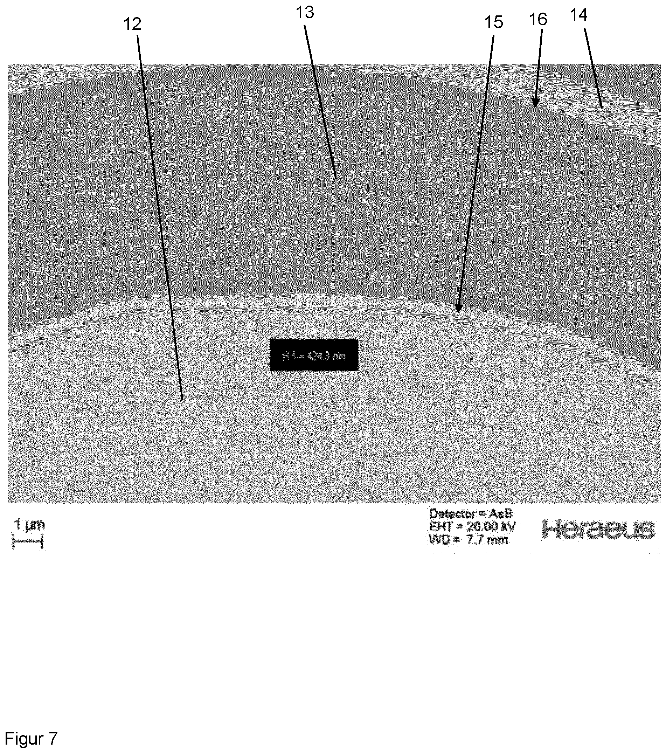

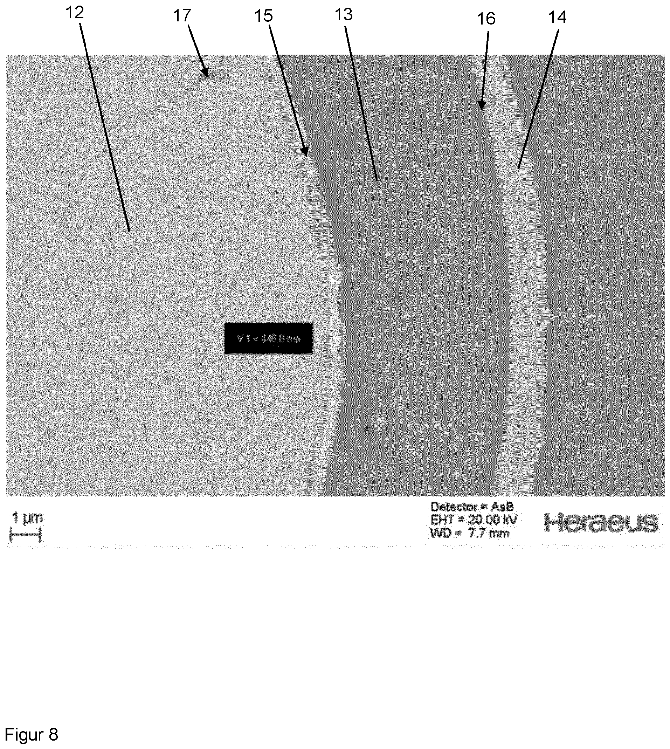

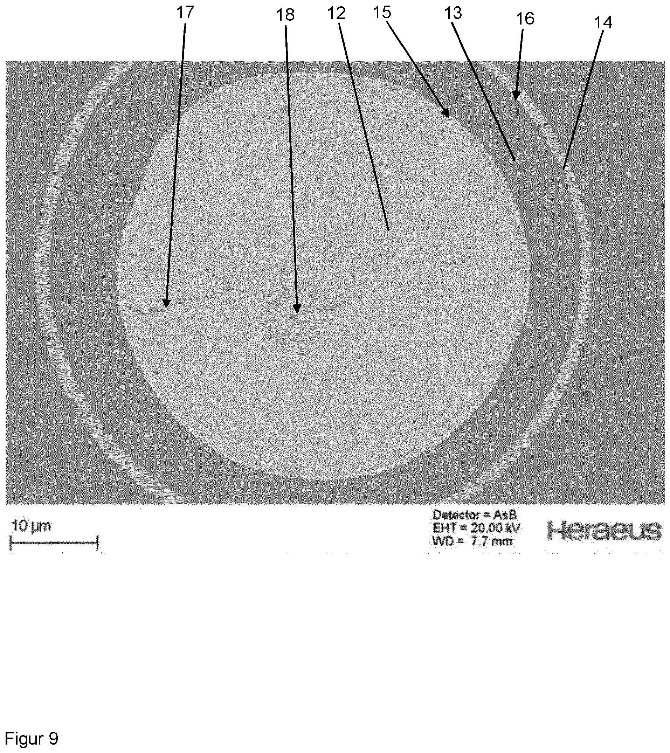

In den Figuren 2 bis 5 und 7 bis 9 sind Aufnahmen von Querschliffen erfindungsgemäßer Manteldrähte 11 gezeigt, die mit einem Rasterelektronenmikroskop (REM) aufgenommen wurden. Der Kontrast entsteht in den Figuren 2 bis 5 durch Rückstreuelektronen und in den Figuren 7 bis 9 durch Sekundärelektronen.

Die Manteldrähte 11 weisen eine Drahtseele 12 aus einer Rhodium-Zirkonium-Legierung mit 20 Gew% Zirkonium und 80 Gew% Rhodium einschließlich üblicher Verunreinigungen auf. Diese Legierung wird auch als RhZr0,2 bezeichnet. Die Rhodium-Zirkonium-Legierung wird durch mehrfaches Umformen kaltverfestigt. Durch das Zirkonium in dem Rhodium lässt sich die Drahtseele 12 besonders fein ziehen. Die hohe Zugfestigkeit erlaubt es, verhältnismäßig dicke Kupferschichten auf die Drahtseele 12 aufzutragen. Reines Rhodium versprödet und kann bei einem Durchmesser zwischen 80 µm und 100 µm oder geringer brechen.

Ein innerer Mantel 13 besteht demzufolge aus Kupfer und ein äußerer Mantel 14 besteht aus einer Palladium-Nickel-Legierung. Der innere Mantel 13 aus Kupfer erhöht die elektrische Leitfähigkeit des Manteldraht und verbessert gleichzeitig die Federeigenschaften des Manteldrahts 11. Der äußere Mantel 14 dient dem Schutz des Kupfers des inneren Mantels 13 vor mechanischen Belastungen und Abnutzungseffekten. Der äußere Mantel 14 ist hierzu härter als der innere Mantel 13. Eine Haftvermittlungsschicht 15 aus Gold ist zwischen der Drahtseele 12 und dem inneren Mantel 13 angeordnet, um die mechanische Anbindung des inneren Mantels 13 an die Drahtseele 12 zu verbessern. Die Haftvermittlungsschicht 15 verbessert so die Lebensdauer des Manteldrahts 11. Es kann so ein Ablösen des Kupfers von der Rhodium-Zirkonium-Legierung der Drahtseele 12 mit der Haftvermittlungsschicht 15 verhindert werden. Zwischen dem inneren Mantel 13 und dem äußeren Mantel 14 kann eine Diffusionsschutzschicht 16 vorgesehen sein, die ein Eindiffundieren von Palladium in das Kupfer des inneren Mantels 13 verhindert. Hiermit wird die Lebensdauer des Manteldrahts 11 erhöht und die elektrische Leitfähigkeit des Manteldrahts 11 bleibt über die Zeit konstanter. Die Diffusionsschutzschicht 16 kann auch aus mehreren unterschiedlichen Diffusionsbarrieren bestehen.

Die Drahtseelen 12 haben einen Durchmesser zwischen 44 µm und 47 µm. Die inneren Mäntel 13 haben eine Schichtstärke zwischen 2,5 µm und 10 µm. Die äußeren Mäntel 14 haben eine Schichtstärke zwischen 1,4 µm und 2 µm. Die Haftvermittlungsschichten 15 haben eine Schichtstärke zwischen 420 nm und 470 nm. Die relativ dicke Kupferschicht als innerer Mantel 13 hat eine starke Steigerung der elektrischen Leitfähigkeit des Manteldrahts 11 zur Folge.

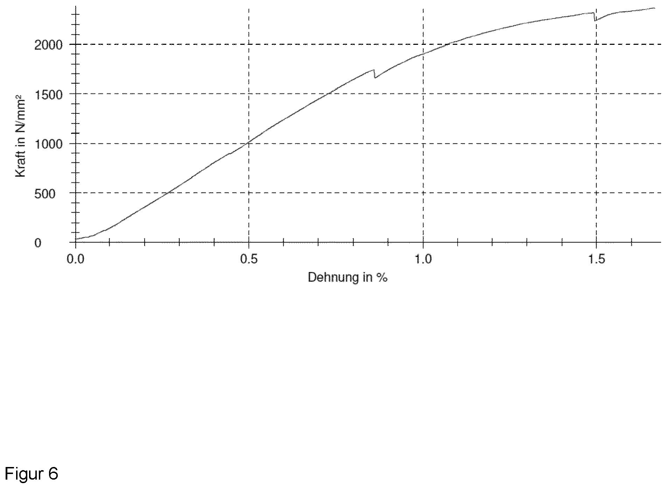

Figur 6 zeigt ein Kraft-Dehnungsdiagramm eines solchen Manteldrahts 11. Der Manteldraht 11 widersteht einer Kraft von etwa 1700 N pro mm². Der Manteldraht 11 hatte einen Durchmesser von 55 µm. Es wurde eine Vorspannkraft von 30 N/mm² verwendet. Die Geschwindigkeit im Fließbereich beträgt 0,00025 s⁻¹.

Das E-Modul m_{E}, die 0,2%-Dehngrenze Rp_{0,2} und die Zugfestigkeit Rₘ werden mit einer Zwick Zugprüfmaschine Z250 bestimmt. Der Zugversuch erfolgte an einem Manteldraht mit 55 µm Drahtdurchmesser und beziehen sich hierauf. Die Prüfgeschwindigkeit bezüglich des E-Moduls m_{E} und der Streckgrenze Rp_{0,2} war 1mm/min, während die Prüfgeschwindigkeit für die Zugfestigkeit Rₘ bei 10mm/min lag.

Die elektrische Leitfähigkeit wurde mit einer 4-Pol Messung des Spannungsabfalles am Prüfling bei definierter Länge mit einem Burster Resistomat 2316 bestimmt. Die Messung erfolgt einem Manteldraht mit einer Drahtlänge zwischen 0,06 m und 0,07 m, einem Durchmesser von 52 µm und einem Messstrom von 10 mA.

Aus den Versuchen ergeben sich die folgenden mechanischen Eigenschaften für den erfindungsgemäßen Manteldraht 11: m_{E} 215,0 kN/mm², R_{eL} 2240 MPa, Rp_{0,2} 2171,8 N/mm², Rₘ 2368,3 N/mm², Fₘ 5,6 N, A 100 mm 0,53 %. Für den Manteldraht ergeben sich für den Quotient Rp_{0,2}/m_{E} 2171,8 MPa / 215 GPa, was einem Verhältnis von 0,0101 entspricht. Im Vergleich hierzu der Quotient Rp_{0,2}/m_{E} für reines Rhodium 2300 MPa / 370 GPa, was einem Verhältnis von nur 0,0062 entspricht.

Je größer der Quotient Rp_{0,2}/m_{E} umso besser ist die Federeigenschaften im elastischen Bereich.

Weitere Experimente zeigten, dass die Federeigenschaften (quantifizierbar durch den Quotient Rp_{0,2}/m_{E}) des Manteldrahts 11 drastisch verbessert werden konnten (68% Verbesserung im Vergleich zu einem Draht aus Rhodium). Des Weiteren konnte die elektrische Leitfähigkeit (LF) um 79% im Vergleich zu einem Draht aus Rhodium gesteigert werden.

**Tabelle 1: Vergleich von physikalischen Eigenschaften des erfindungsgemäßen Manteldrahts im Vergleich zu einem Draht aus Rhodium**

| | Rhodium | Manteldraht |
|---|---|---|
| E-Modul m_{E} | 370 GPa | 215 GPa |
| LF | 32 % IACS | 57,5 % IACS |
| Rp_{0,2} | 2300 MPa | 2171,8 MPa |
| Rp_{0,2}/m_{E} | 0,006 | 0,010 |

Die elektrische Leitfähigkeit (LF) erfolgt mit einer 4-Pol-Messung zur Messung des Spannungsabfalls an einem Prüfkörper des Rhodium-Drahts beziehungsweise Manteldrahts bei definierter Länge. Zur Messung wurde ein BURSTER^{®} Resistomat 2316 verwendet. Die Messung erfolgt bei Raumtemperatur (22°C).

Bei einer Länge von 70 mm und einem Durchmesser von 52 µm bei einer Querschnittsfläche von 0,0021 mm² eines Manteldrahts nach den Figuren 2 bis 5 und 7 bis 9 ergab sich ein Widerstand von 1,00 Ohm. Daraus ergibt sich ein spezifischer elektrischer Widerstand R_{spez} von 0,030 Ohm mm² / m, eine elektrische Leitfähigkeit von 32,90 m / (Ohm mm²) beziehungsweise 56,7 % IACS. Bei einer Länge von 50 mm und einem Durchmesser von 52 µm bei einer Querschnittsfläche von 0,0021 mm² eines Manteldrahts nach den Figuren 2 bis 5 und 7 bis 9 ergab sich ein Widerstand von 0,70 Ohm. Daraus ergibt sich ein spezifischer elektrischer Widerstand R_{spez} von 0,030 Ohm mm² / m, eine elektrische Leitfähigkeit von 33,73 m / (Ohm mm²) beziehungsweise 58,2 % IACS. 100% IACS entsprechen 58 m / (Ohm mm²).

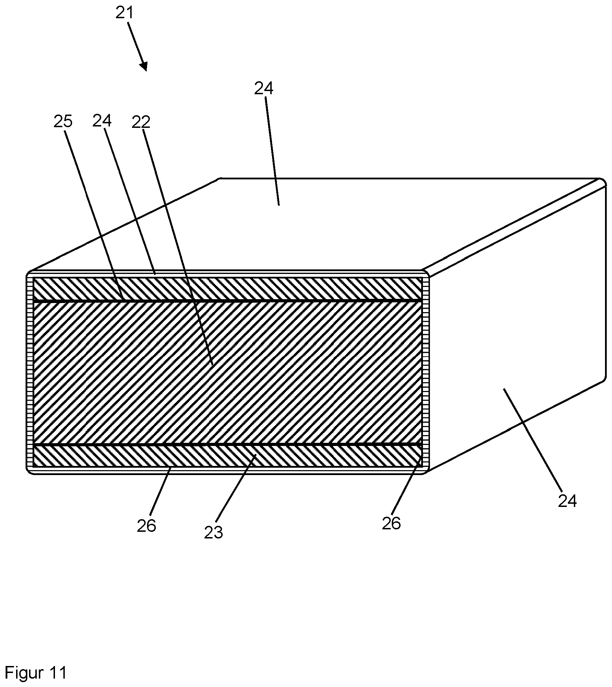

Alternativ zu dem in Figur 1 gezeigten Manteldraht 1, kann auch eine bandförmige Drahtseele 22 zur Herstellung eines Manteldrahts 21 verwendet werden, wie er in Figur 11 gezeigt ist.

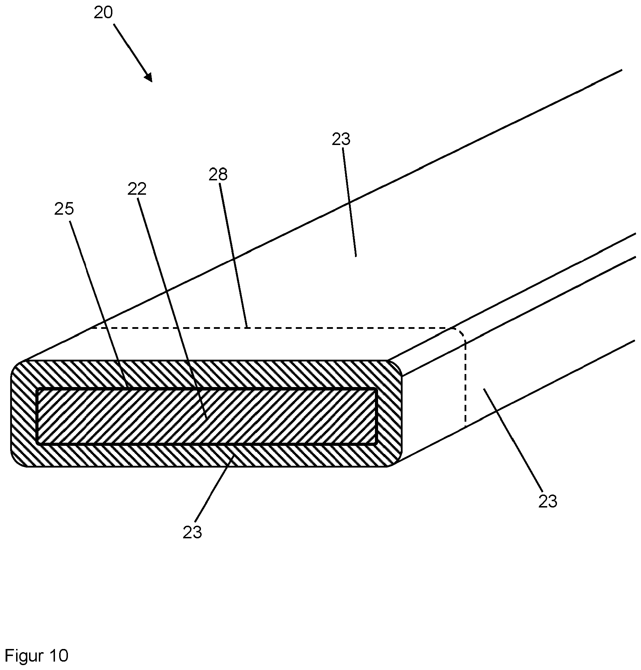

Figur 10 zeigt eine schematische perspektivische Querschnittansicht auf ein Zwischenprodukt 20 zur Herstellung eines erfindungsgemäßen bandförmigen Manteldrahts 21. Die Figuren 10 und 11 zeigen die Herstellung eines bandförmigen Manteldrahts 21 über das Zwischenprodukt 20, das in Figur 10 gezeigt ist. Figur 11 zeigt eine schematische perspektivische Querschnittansicht auf den erfindungsgemäßen Manteldraht 21. Der Manteldraht 21 besteht aus einer Drahtseele 22 aus Rhodium oder einer Rhodium-Basis-Legierung, einem inneren Mantel 23 aus Kupfer oder Silber oder Aluminium oder einer Kupfer-Basis-Legierung oder einer Silber-Basis-Legierung oder einer Aluminium-Basis-Legierung, einem äußeren Mantel 24 aus einem Metall oder einer Metalllegierung und einer Haftvermittlungsschicht 25 aus Gold oder einer Gold-Basis-Legierung. Optional kann eine metallische Diffusionsschutzschicht 26 zwischen dem inneren Mantel 23 und dem äußeren Mantel 24 vorgesehen sein.

Die bandförmige Drahtseele 22 hat zunächst einen rechteckigen Querschnitt, so wie das in Figur 10 gezeigt ist. Diese bandförmige Drahtseele 22 wird mit der Haftvermittlungsschicht 25 und dem inneren Mantel 23 beschichtet. Anschließend wird die so beschichtete Drahtseele 22, also das Zwischenprodukt 20, senkrecht zu einer Längsrichtung der bandförmigen Drahtseele 22 (in Figur 10 in die Bildebene hinein) in viele Stücke geschnitten. Eine der Schnittebenen ist in Figur 10 durch eine gestrichelte Linie als Schnittebene 28 angedeutet. Die so geschnittenen Stücke der beschichteten Drahtseele 22 sind auf zwei gegenüberliegenden Seiten mit der Haftvermittlungsschicht 25 und dem inneren Mantel 23 beschichtet. Diese Stücke werden anschließend galvanisch mit der Diffusionsschutzschicht 26 und danach mit dem äußeren Mantel 24 beschichtet oder nur mit dem äußeren Mantel 24 beschichtet. Als Ergebnis erhält man den Manteldraht 21, so wie er in Figur 11 gezeigt ist.

Die Drahtseele 22 verläuft im Innersten des Manteldrahts 21. Der innere Mantel 23 bedeckt die Drahtseele 22 an zwei gegenüberliegenden Seiten. Der äußere Mantel 24 umschließt den inneren Mantel 23 und die Drahtseele 22 und besteht aus einem Metall oder einer Metalllegierung mit einer größeren Härte als das Material des inneren Mantels 23, wie beispielsweise aus Rhodium, einer Rhodium-Basis-Legierung, einer Kupfer-Zinn-Zink-Legierung, einer Palladium-Nickel-Legierung oder einer Gold-Basis-Legierung besteht, wobei vorzugsweise die Gold-Basis-Legierung eine Gold-Kobalt-Legierung, eine Gold-Eisen-Legierung oder eine Gold-Nickel-Legierung ist. Die Haftvermittlungsschicht 25 ist zwischen der Drahtseele 22 und dem inneren Mantel 23 angeordnet. Die Diffusionsschutzschicht 26 kann zwischen dem äußeren Mantel 24 und dem inneren Mantel 23 und auch zwischen dem äußeren Mantel 24 und der Drahtseele 22 angeordnet sein und die Migration von Atomen und Ionen aus dem äußeren Mantel 24 in den inneren Mantel 23 verhindern beziehungsweise erschweren, damit diese nicht die elektrische Leitfähigkeit des inneren Mantels 23 beeinträchtigen.

Die Drahtseele 22 kann eine Breite von etwa 100 µm und eine Dicke von etwa 30 µm haben, der innere Mantel 23 kann eine Schichtstärke von etwa 10 µm haben und der äußere Mantel 24 kann eine Schichtstärke von etwa 2 µm haben. Die Haftvermittlungsschicht 25 und die Diffusionsschutzschicht 26 können dünner als 1 µm ausgebildet sein.

Zur Herstellung des Manteldrahts 21 kann zunächst die bandförmige Drahtseele 22 aus einer Schmelze durch Erstarren und durch anschließendes Ziehen und Walzen der Drahtseele 22 als Band gewonnen werden. Die Drahtseele 22 wird vorzugsweise kaltverfestigt, um die mechanischen Eigenschaften der Drahtseele 22 zu verbessern. Die Oberfläche der Drahtseele 22 kann dann vor den folgenden Beschichtungsverfahren gereinigt werden. Die Drahtseele 22 kann aber auch mit einem anderen Verfahren hegestellt und zur weiteren Verarbeitung bereitgestellt werden.

Anschließend kann die Haftvermittlungsschicht 25 galvanisch auf die bandförmige Drahtseele 22 aufgetragen werden. Danach kann der innere Mantel 23 galvanisch auf die mit der Haftvermittlungsschicht 25 beschichtete Drahtseele 22 aufgetragen werden, um das Zwischenprodukt 20 zu erhalten. Nach dem Schneiden des Zwischenprodukts 20 können die geschnittenen Stücke galvanisch mit der Diffusionsschutzschicht 26 beschichtet werden. Als letztes kann der äußere Mantel 24 galvanisch auf die Diffusionsschutzschicht 26 oder direkt auf den inneren Mantel 23 beziehungsweise die Drahtseele 22 aufgetragen werden.

Der so hergestellte bandförmige Manteldraht 21 kann optional mit einer Wärmebehandlung nachbehandelt werden. Aus dem Manteldraht 21 können auch mehrere bandförmige Drahtstücke des Manteldrahts 21 als Arrays beabstandet zueinander angeordnet werden, um Prüfnadelarrays zu formen.

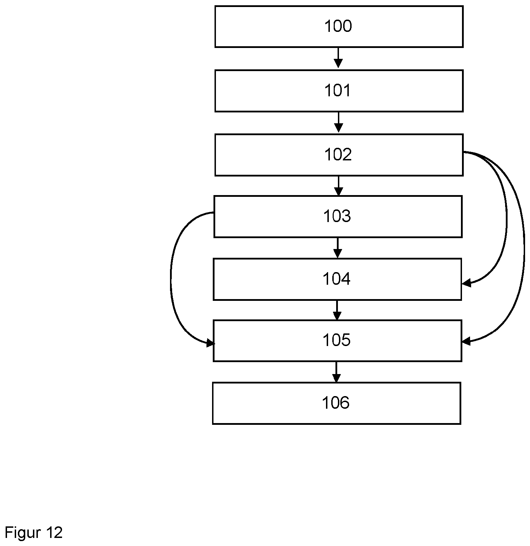

Im Folgenden wird anhand von Figur 12 zusammen mit den Figuren 10 und 11 und Figur 1 der Ablauf eines erfindungsgemäßen Verfahrens geschildert.

In einem ersten Arbeitsschritt 100 kann die Drahtseele 2, 22 aus der Schmelze und durch Ziehen hergestellt werden. Als Material für die Drahtseele kann eine RhZr0,2-Legierung verwendet werden. Die Drahtseele 2, 22 kann kaltverfestigt werden, um die mechanischen Eigenschaften, insbesondere die Federeigenschaften des zu erzeugenden Manteldrahts zu verbessern. Die Oberfläche der Drahtseele 2, 22 kann vor der Weiterverarbeitung gereinigt werden.

In einem zweiten Arbeitsschritt 101 kann die Drahtseele 2, 22 mit einer dünnen Goldschicht als Haftvermittlungsschicht 5, 25 galvanisch beschichtet werden.

In einem dritten Arbeitsschritt 102 kann eine Kupfer-Schicht oder einer Silber-Schicht oder eine Aluminium-Schicht galvanisch auf die mit der Haftvermittlungsschicht 5, 25 beschichtete Drahtseele 2, 22 als innerer Mantel 3, 23 aufgetragen werden.

In einem optionalen vierten Arbeitsschritt 103 kann das Zwischenprodukt 20, das heißt die beschichtete bandförmige Drahtseele 22 senkrecht zur Längsachse der bandförmigen Drahtseele in Stücke geschnitten werden, so wie das in Figur 10 durch die gestrichelte Linie als Schnittebene 28 angedeutet ist.

In einem optionalen fünften Arbeitsschritt 104 kann auf dem inneren Mantel 3, 23 und gegebenenfalls auch auf offen liegende Oberflächen der Drahtseele 22 eine Diffusionsschutzschicht 6, 26 aus Nickel aufgetragen werden.

In einem sechsten Arbeitsschritt 105 kann auf dem inneren Mantel 3, 23 und gegebenenfalls auch auf offen liegende Oberflächen der Drahtseele 22 oder auf der Diffusionsschutzschicht 6, 26 galvanisch eine Schicht aus Rhodium, einer Rhodium-Basis-Legierung, einer Gold-Basis-Legierung, einer Gold-Kobalt-Legierung, einer Gold-Eisen-Legierung, einer Gold-Nickel-Legierung, einer Kupfer-Zinn-Zink-Legierung oder einer Palladium-Nickel-Legierung als äußerer Mantel 4, 24 aufgetragen werden. Anschließend kann optional in einem siebten Arbeitsschritt 106 eine Wärmebehandlung des so erzeugten Manteldrahts 1, 21 erfolgen.

### Bezugszeichenliste

- 1, 11, 21: Manteldraht
- 2, 12, 22: Drahtseele
- 3, 13, 23: Innerer Mantel
- 4, 14, 24: Äußerer Mantel
- 5, 15, 25: Haftvermittlungsschicht
- 6, 16, 26: Diffusionsschutzschicht
- 20: Zwischenprodukt
- 28: Schnittebene
- 100: erster Arbeitsschritt
- 101: zweiter Arbeitsschritt
- 102: dritter Arbeitsschritt
- 103: vierter Arbeitsschritt
- 104: fünfter Arbeitsschritt
- 105: sechster Arbeitsschritt
- 106: siebter Arbeitsschritt

## Patentansprüche

1. Manteldraht (1, 11, 21) zur Herstellung von Prüfnadeln oder Schleifkontakten aufweisend
eine Drahtseele (2, 12, 22) aus Rhodium oder einer Rhodium-Basis-Legierung, einen inneren Mantel (3, 13, 23) aus Kupfer oder Silber oder Aluminium oder einer Kupfer-Basis-Legierung oder einer Silber-Basis-Legierung oder einer Aluminium-Basis-Legierung, wobei der innere Mantel (3, 13, 23) die Drahtseele (2, 12, 22) an zumindest zwei gegenüberliegenden Seiten bedeckt oder vollständig umschließt,
eine Haftvermittlungsschicht (5, 15, 25) aus Gold oder einer Gold-Basis-Legierung, die zwischen der Drahtseele (2, 12, 22) und dem inneren Mantel (3, 13, 23) angeordnet ist, und
einen äußeren Mantel (4, 14, 24) aus einem Metall oder einer Metalllegierung mit einer größeren Härte als das Material des inneren Mantels (3, 13, 23), wobei der äußere Mantel (4, 14, 24) den inneren Mantel (3, 13, 23) umschließt.

2. Manteldraht (1, 11, 21) nach Anspruch 1, **dadurch gekennzeichnet, dass** dass das Volumen der Drahtseele (2, 12, 22) zumindest genauso groß ist wie das Volumen des inneren Mantels (3, 13, 23), bevorzugt das Volumen der Drahtseele (2, 12, 22) genauso groß oder bis zu 20-mal größer ist wie das Volumen des inneren Mantels (3, 13, 23), und/oder
die Drahtseele (2, 12, 22) und der innere Mantel (3, 13, 23) mindestens eine doppelt so große Dicke beziehungsweise Schichtstärke aufweisen wie die Haftvermittlungsschicht (5, 15, 25), insbesondere eine mindestens dreimal so große Dicke beziehungsweise Schichtstärke aufweisen wie die Haftvermittlungsschicht (5, 15, 25).

3. Manteldraht (1, 11, 21) nach Anspruch 1 oder 2, **dadurch gekennzeichnet, dass** zwischen dem inneren Mantel (3, 13, 23) und dem äußeren Mantel (4, 14, 24) eine Diffusionsschutzschicht (6, 16, 26) als Diffusionsbarriere angeordnet ist, wobei vorzugsweise die Diffusionsschutzschicht (6, 16, 26) aus Nickel oder Gold oder einer Nickel-Basis-Legierung oder einer Gold-Basislegierung besteht.

4. Manteldraht (1, 11, 21) nach Anspruch 3, **dadurch gekennzeichnet, dass** der innere Mantel (3, 13, 23) mindestens eine doppelt so große Schichtstärke aufweist wie die Diffusionsschutzschicht (6, 16, 26), bevorzugt der innere Mantel (3, 13, 23) mindestens eine dreimal so große Schichtstärke aufweist wie die Diffusionsschutzschicht (6, 16, 26).

5. Manteldraht (1, 11, 21) nach einem der vorangehenden Ansprüche, **dadurch gekennzeichnet, dass**
der äußere Mantel (4, 14, 24) aus Rhodium, einer Rhodium-Basis-Legierung, einer Kupfer-Zinn-Zink-Legierung, einer Palladium-Nickel-Legierung oder einer Gold-Basis-Legierung besteht, wobei vorzugsweise die Gold-Basis-Legierung eine Gold-Kobalt-Legierung, eine Gold-Eisen-Legierung oder eine Gold-Nickel-Legierung ist.

6. Manteldraht (1, 11, 21) nach einem der vorangehenden Ansprüche, **dadurch gekennzeichnet, dass**
der Manteldraht (1, 11, 21) bei Raumtemperatur ein E-Modul m_{E} von mindestens 150 GPa aufweist, bevorzugt von mindestens 200 GPa aufweist, besonders bevorzugt von 215 GPa aufweist, und/oder
der Manteldraht (1, 11, 21) bei Raumtemperatur eine 0,2%-Dehngrenze Rp_{0,2} (Elastizitätsgrenze) von mindestens 1800 MPa aufweist, bevorzugt von mindestens 2000 MPa aufweist, besonders bevorzugt von 2150 MPa aufweist, und/oder
der Manteldraht (1, 11, 21) bei Raumtemperatur eine elektrische Leitfähigkeit von mindestens 40% IACS aufweist, bevorzugt von mindestens 50% IACS aufweist, besonders bevorzugt von 57% IACS aufweist

7. Manteldraht (1, 11, 21) nach einem der vorangehenden Ansprüche, **dadurch gekennzeichnet, dass**
der Manteldraht (1, 11, 21) einen Durchmesser oder eine Dicke von maximal 200 µm aufweist, bevorzugt einen Durchmesser oder eine Dicke zwischen 10 µm und 100 µm aufweist, ganz besonders bevorzugt einen Durchmesser oder eine Dicke zwischen 20 µm und 70 µm aufweist.

8. Manteldraht (1, 11, 21) nach einem der vorangehenden Ansprüche, **dadurch gekennzeichnet, dass**
die Drahtseele (2, 12, 22) einen Durchmesser oder eine Dicke zwischen 9 µm und 100 µm aufweist, bevorzugt zwischen 20 µm und 70 µm aufweist, ganz besonders bevorzugt einen Durchmesser oder eine Dicke zwischen 30 µm und 60 µm aufweist, und/oder
der innere Mantel (3, 13, 23) eine Schichtstärke zwischen 1 µm und 20 µm aufweist, bevorzugt zwischen 5 µm und 15 µm aufweist, und/oder der äußere Mantel (4, 14, 24) eine Schichtstärke zwischen 0,5 µm und 5 µm aufweist, bevorzugt zwischen 1 µm und 3 µm aufweist, und/oder die Haftvermittlungsschicht (5, 15, 25) eine Schichtstärke zwischen 100 nm und 1000 nm aufweist, bevorzugt zwischen 300 nm und 600 nm aufweist.

9. Manteldraht (1, 11, 21) nach einem der vorangehenden Ansprüche, **dadurch gekennzeichnet, dass**
die Haftvermittlungsschicht (5, 15, 25), der innere Mantel (3, 13, 23), der äußere Mantel (4, 14, 24) und gegebenenfalls die Diffusionsschutzschicht galvanische Beschichtungen sind.

10. Manteldraht (1, 11, 21) nach einem der vorangehenden Ansprüche, **dadurch gekennzeichnet, dass**
die Drahtseele (2, 12, 22) kaltverfestigt ist und/oder
die Drahtseele (22) ein Band ist, insbesondere ein beschichtetes Band ist.

11. Verfahren zur Herstellung eines Manteldrahts (1, 11, 21), insbesondere eines Manteldrahts (1, 11, 21) nach einem der vorangehenden Ansprüche, **gekennzeichnet durch** die folgenden chronologischen Schritte
A) Bereitstellen einer Drahtseele (2, 12, 22) aus Rhodium oder einer Rhodium-Basis-Legierung,
B) Beschichten der Drahtseele (2, 12, 22) mit einer Haftvermittlungsschicht (5, 15, 25) aus Gold oder einer Gold-Basis-Legierung,
C) Beschichten der mit der Haftvermittlungsschicht (5, 15, 25) beschichteten Drahtseele (2, 12, 22) mit einem inneren Mantel (3, 13, 23) aus Kupfer oder Silber oder Aluminium oder einer Kupfer-Basis-Legierung oder einer Silber-Basis-Legierung oder einer Aluminium-Basis-Legierung, und
D) Beschichten der mit der Haftvermittlungsschicht (5, 15, 25) und dem inneren Mantel (3, 13, 23) beschichteten Drahtseele (2, 12, 22) mit einem äußeren Mantel (4, 14, 24) aus einem Metall oder einer Metalllegierung mit einer größeren Härte als das Material des inneren Mantels (3, 13, 23).

12. Verfahren nach Anspruch 11, **dadurch gekennzeichnet, dass** die Drahtseele (22) bandförmig ist und zwischen Schritt C) und D) ein Schritt C1) erfolgt:
C1) Schneiden der beschichteten bandförmigen Drahtseele (22) senkrecht zu einer Längsachse des Bands in eine Vielzahl von beschichteten Drahtseelen (22), bei denen die Drahtseelen (22) an zwei gegenüberliegenden Seiten von der Haftvermittlungsschicht (25) und dem inneren Mantel (23) beschichtet sind, und wobei
in Schritt D) jede der beschichteten Drahtseelen (22) mit dem äußeren Mantel (24) beschichtet wird.

13. Verfahren nach Anspruch 11 oder 12, **dadurch gekennzeichnet, dass** zwischen Schritt C) und D) ein Schritt C2) erfolgt:
C2) Beschichten der mit der Haftvermittlungsschicht (5, 15, 25) und dem inneren Mantel (3, 13, 23) beschichteten Drahtseele (2, 12, 22) mit einer Diffusionsschutzschicht, vorzugsweise mit einer Diffusionsschutzschicht aus Nickel oder Gold oder einer Nickel-Basis-Legierung oder einer Gold-Basis-Legierung, und wobei in Schritt D) das Beschichten des mit der Haftvermittlungsschicht (5, 15, 25), dem inneren Mantel (3, 13, 23) und der Diffusionsschutzschicht beschichteten Drahtseele (2, 12, 22) mit dem äußeren Mantel (4, 14, 24) erfolgt.

14. Verfahren nach einem der Ansprüche 11 bis 13, **dadurch gekennzeichnet, dass** die Beschichtungen nach den Schritten B), C) und D) und gegebenenfalls C2) mit einem galvanischen Verfahren aufgebracht werden und/oder mit einem physikalischen Verfahren, insbesondere mit physikalischer Gasphasenabscheidung (PVD), aufgebracht werden.

15. Prüfnadel aufweisend zumindest einen Manteldraht (1, 11, 21) nach einem der Ansprüche 1 bis 10 oder hergestellt aus einem Manteldraht (1, 11, 21), der mit einem Verfahren nach einem der Ansprüche 11 bis 14 hergestellt wurde, wobei vorzugsweise die Prüfnadel senkrecht zur Zylinderachse des Manteldrahts (1, 11) oder senkrecht zu einer Längsachse des Manteldrahts (1, 11, 21) gebogen ist.

16. Prüfnadelarray aufweisend mehrere zueinander beabstandete Prüfnadeln nach Anspruch 15.

17. Schleifkontakt aufweisend mehrere Manteldrähte (1, 11, 21) nach einem der Ansprüche 1 bis 10 oder hergestellt aus einem Manteldraht (1, 11, 21), der mit einem Verfahren nach einem der Ansprüche 11 bis 14 hergestellt wurde, wobei vorzugsweise die Manteldrähte (1, 11, 21) ein Drahtbündel bilden.

## Claims

1. A clad wire (1, 11, 21) for producing test needles or sliding contacts having a wire core (2, 12, 22) made of rhodium or a rhodium-based alloy,
an inner cladding (3, 13, 23) made of copper or silver or aluminum or a copper-based alloy or a silver-based alloy or an aluminum-based alloy, wherein the inner cladding (3, 13, 23) covers the wire core (2, 12, 22) on at least two opposite sides or completely encloses the wire core (2, 12, 22),
an adhesion-promoting layer (5, 15, 25) made of gold or a gold-based alloy, which is arranged between the wire core (2, 12, 22) and the inner cladding (3, 13, 23), and
an outer cladding (4, 14, 24) made of a metal or a metal alloy having a greater hardness than the material of the inner cladding (3, 13, 23), wherein the outer cladding (4, 14, 24) encloses the inner cladding (3, 13, 23).

2. The clad wire (1, 11, 21) according to Claim 1, **characterized in that** the volume of the wire core (2, 12, 22) is at least as large as the volume of the inner cladding (3, 13, 23), preferably the volume of the wire core (2. 12, 22) is just as large or up to 20 times greater than the volume of the inner cladding (3, 13, 23), and/or
the wire core (2, 12, 22) and the inner cladding (3, 13, 23) have a thickness or layer thickness at least twice as large as the adhesion-promoting layer (5, 15 25), in particular a thickness or layer thickness which is at least three times as large as the adhesion-promoting layer (5, 15, 25).

3. The clad wire (1, 11, 21) according to Claim 1 or 2, **characterized in that** a diffusion protection layer (6, 16, 26) is arranged as a diffusion barrier between the inner cladding (3, 13, 23) and the outer cladding (4, 14, 24), wherein the diffusion protection layer (6, 16, 26) preferably consists of nickel or gold or a nickel-based alloy or a gold-based alloy.

4. The clad wire (1, 11, 21) according to Claim 3, **characterized in that** the inner cladding (3, 13, 23) has a layer thickness at least twice as large as the diffusion protection layer (6, 16, 26), preferably the inner cladding (3, 13, 23) has a layer thickness which is at least three times as large as the diffusion protection layer (6, 16, 26).

5. The clad wire (1, 11, 21) according to any one of the preceding claims, **characterized in that**
the outer cladding (4, 14, 24) consists of rhodium, a rhodium-based alloy, a copper-tin-zinc alloy, a palladium-nickel alloy or a gold-based alloy, wherein the gold-based alloy preferably is a gold-cobalt alloy, a gold-iron alloy or a gold-nickel alloy.

6. The clad wire (1, 11, 21) according to any one of the preceding claims, **characterized in that**
the clad wire (1, 11, 21) at room temperature has a modulus of elasticity m_{E} of at least 150 GPa , preferably at least 200 GPa, particularly preferably 215 GPa, and/or
the clad wire (1, 11, 21) at room temperature has a 0.2% offset yield strength Rp_{0.2} (elasticity limit) of at least 1800 MPa, preferably of at least 2000 MPa, particularly preferably of 2150 MPa, and/or
the clad wire (1, 11, 21) at room temperature has an electrical conductivity of at least 40% IACS, preferably of at least 50% IACS, particularly preferably of 57% IACS.

7. The clad wire (1, 11, 21) according to any one of the preceding claims, **characterized in that**
the clad wire (1, 11, 21) has a diameter or a thickness of at most 200 µm, preferably a diameter or a thickness of between 10 µm and 100 µm, very particularly preferably has a diameter or a thickness of between 20 µm and 70 µm.

8. The clad wire (1, 11, 21) according to any one of the preceding claims, **characterized in that**
the wire core (2, 12, 22) has a diameter or a thickness of between 9 µm and 100 µm, preferably between 20 µm and 70 µm, very particularly preferably has a diameter or a thickness of between 30 µm and 60 µm, and/or
the inner cladding (3, 13, 23) has a layer thickness of between 1 µm and 20 µm, preferably between 5 µm and 15 µm, and/or
the outer cladding (4, 14, 24) has a layer thickness of between 0.5 µm and 5 µm, preferably between 1 µm and 3 µm, and/or
the adhesion-promoting layer (5, 15, 25) has a layer thickness of between 100 nm and 1000 nm, preferably between 300 nm and 600 nm.

9. The clad wire (1, 11, 21) according to any one of the preceding claims, **characterized in that**
the adhesion-promoting layer (5. 15, 25), the inner cladding (3, 13, 23), the outer cladding (4, 14, 24) and optionally the diffusion protection layer are galvanic coatings.

10. The clad wire (1, 11, 21) according to any one of the preceding claims, **characterized in that**
the wire core (2, 12, 22) is work-hardened and/or
the wire core (22) is a strip, in particular a coated strip.

11. A method for producing a clad wire (1, 11, 21), in particular a clad wire (1, 11, 21) according to any one of the preceding claims, **characterized by** the following chronological steps
A) providing a wire core (2, 12, 22) made of rhodium or a rhodium-based alloy,
B) coating the wire core (2, 12, 22) with an adhesion-promoting layer (5, 15, 25) made of gold or a gold-based alloy,
C) coating the wire core (2, 12, 22), coated with the adhesion-promoting layer (5, 15, 25), with an inner cladding (3, 13, 23) of copper or silver or aluminum or a copper-based alloy or a silver-based alloy or an aluminum-based alloy, and
D) coating the wire core (2, 12, 22), coated with the adhesion-promoting layer (5, 15, 25) and the inner cladding (3, 13, 23), with an outer cladding (4, 14, 24) made of a metal or a metal alloy with a greater hardness than the material of the inner cladding (3, 13, 23).

12. The method according to Claim 11, **characterized in that** the wire core (22) is shaped strip-like and a step C1) takes place between steps C) and D):
C1) cutting the coated strip-like wire core (22) perpendicular to a longitudinal axis of the strip-like wire core (22) into a plurality of coated wire cores (22), in which the wire cores (22) are coated on two opposite sides by the adhesion-promoting layer (25) and the inner cladding (23), and wherein
in step D) each of the coated wire cores (22) is coated with the outer cladding (24).

13. The method according to Claim 11 or 12, **characterized in that** a step C2) is carried out between steps C) and D):
C2) coating of the wire core (2, 12, 22), coated with the adhesion-promoting layer (5, 15, 25) and the inner cladding (3, 13, 23), with a diffusion protection layer, preferably with a diffusion protection layer made of nickel or gold or a nickel-based alloy or a gold-based alloy, and wherein in step D) the wire core (2, 12, 22), coated with the adhesion-promoting layer (5, 15, 25), the inner cladding (3, 13, 23) and the diffusion protection layer, is coated with the outer cladding (4, 14, 24).

14. The method according to any one of Claims 11 to 13, **characterized in that** the coatings according to steps B), C) and D) and optionally C2) are applied using a galvanic method and/or are applied using a physical method, in particular using physical vapor deposition (PVD).

15. A test needle comprising at least one clad wire (1, 11, 21) according to any one of Claims 1 to 10 or manufactured from a clad wire (1, 11, 21) which has been produced by a method according to any one of Claims 11 to 14, wherein preferably the test needle is bent perpendicular to the cylinder axis of the clad wire (1, 11) or perpendicular to a longitudinal axis of the clad wire (1, 11, 21).

16. A test needle array having a plurality of test needles according to Claim 15 spaced apart from one another.

17. A sliding contact comprising a plurality of clad wires (1, 11, 21) according to any one of Claims 1 to 10 or manufactured from a clad wire (1, 11, 21) which has been produced by a method according to any one of Claims 11 to 14, wherein preferably the clad wires (1, 11, 21) form a wire bundle.

## Revendications

1. Fil sous gaine (1, 11, 21) destiné à la fabrication d'aiguilles de test ou de contacts abrasifs présentant
une âme de fil (2, 12, 22) en rhodium ou en un alliage à base de rhodium, une gaine intérieure (3, 13, 23) en cuivre ou argent ou aluminium ou en un alliage à base de cuivre ou un alliage à base d'argent ou un alliage à base d'aluminium, la gaine intérieure (3, 13, 23) recouvrant l'âme de fil (2, 12, 22) sur au moins deux côtés opposés ou l'entourant entièrement,
une couche conférant de l'adhérence (5, 15, 25) en or ou en un alliage à base d'or, qui est disposée entre l'âme de fil (2, 12, 22) et la gaine intérieure (3, 13, 23) et
une gaine extérieure (4, 14, 24) en un métal ou en un alliage métallique avec une dureté supérieure au matériau de la gaine intérieure (3, 13, 23), la gaine extérieure (4, 14, 24) entourant la gaine intérieure (3, 13, 23).

2. Fil sous gaine (1, 11, 21) selon la revendication 1, **caractérisé en ce que que** le volume de l'âme de fil (2, 12, 22) est au moins égal au volume de la gaine intérieure (3, 13, 23), de préférence le volume de l'âme de fil (2, 12, 22) est égal au volume de la gaine intérieure (3, 13, 23) ou jusqu'à 20 fois plus important que celui-ci et/ou l'âme de fil (2, 12, 22) et la gaine intérieure (3, 13, 23) présentent au moins une épaisseur ou une épaisseur de couche deux fois plus importante que la couche conférant de l'adhérence (5, 15, 25), en particulier une épaisseur ou une épaisseur de couche au moins trois fois plus importante que la couche conférant de l'adhérence (5, 15, 25).

3. Fil sous gaine (1, 11, 21) selon la revendication 1 ou 2, **caractérisé en ce qu'**une couche antidiffusion (6, 16, 26) sous la forme d'une barrière de diffusion est disposée entre la gaine intérieure (3, 13, 23) et la gaine extérieure (4, 14, 24), la couche antidiffusion (6, 16, 26) étant de préférence constituée de nickel ou d'or ou d'un alliage à base de nickel ou d'un alliage à base d'or.

4. Fil sous gaine (1, 11, 21) selon la revendication 3, **caractérisé en ce que** la gaine intérieure (3, 13, 23) présente une épaisseur de couche au moins deux fois plus importante que la couche antidiffusion (6, 16, 26), de préférence la gaine intérieure (3, 13, 23) présente au moins une épaisseur de couche trois fois plus importante que la couche antidiffusion (6, 16, 26).

5. Fil sous gaine (1, 11, 21) selon l'une quelconque des revendications précédentes, **caractérisé en ce que**
la gaine extérieure (4, 14, 24) est constituée de rhodium, d'un alliage à base de rhodium, d'un alliage de cuivre, d'étain et de zinc, d'un alliage de palladium et de nickel ou d'un alliage à base d'or, l'alliage à base d'or étant de préférence un alliage d'or et de cobalt, un alliage d'or et de fer ou un alliage d'or et de nickel.

6. Fil sous gaine (1, 11, 21) selon l'une quelconque des revendications précédentes, **caractérisé en ce que**
le fil sous gaine (1, 11, 21) présente, à température ambiante, un module E m_{E} d'au moins 150 GPa, de préférence d'au moins 200 GPa, de manière particulièrement préférée de 215 GPa et/ou
le fil sous gaine (1, 11, 21) présente, à température ambiante, une limite d'extension à 0,2 % Rp_{0,2} (limite d'élasticité) d'au moins 1800 MPa, de préférence d'au moins 2000 MPa, de manière particulièrement préférée de 2150 MPa et/ou le fil sous gaine (1, 11, 21) présente, à température ambiante, une conductivité électrique d'au moins 40 % IACS, de préférence d'au moins 50 % IACS, de manière particulièrement préférée de 57 % IACS

7. Fil sous gaine (1, 11, 21) selon l'une quelconque des revendications précédentes, **caractérisé en ce que**
le fil sous gaine (1, 11, 21) présente un diamètre ou une épaisseur de 200 µm maximum, de préférence un diamètre ou une épaisseur compris entre 10 µm et 100 µm, de manière tout particulièrement préférée un diamètre ou une épaisseur compris entre 20 µm et 70 µm.

8. Fil sous gaine (1, 11, 21) selon l'une quelconque des revendications précédentes, **caractérisé en ce que**
l'âme de fil (2, 12, 22) présente un diamètre ou une épaisseur compris entre 9 µm et 100 µm, de préférence entre 20 µm et 70 µm, de manière tout particulièrement préférée un diamètre ou une épaisseur compris entre 30 µm et 60 µm et/ou
la gaine intérieure (3, 13, 23) présente une épaisseur de couche comprise entre 1 µm et 20 µm, de préférence entre 5 µm et 15 µm et/ou
la gaine extérieure (4, 14, 24) présente une épaisseur de couche comprise entre 0,5 µm et 5 µm, de préférence entre 1 µm et 3 µm et/ou
la couche conférant de l'adhérence (5, 15, 25) présente une épaisseur de couche comprise entre 100 nm et 1000 nm, de préférence entre 300 nm et 600 nm.

9. Fil sous gaine (1, 11, 21) selon l'une quelconque des revendications précédentes, **caractérisé en ce que**
la couche conférant de l'adhérence (5, 15, 25), la gaine intérieure (3, 13, 23), la gaine extérieure (4, 14, 24) et le cas échéant la couche antidiffusion sont des revêtements galvaniques.

10. Fil sous gaine (1, 11, 21) selon l'une quelconque des revendications précédentes, **caractérisé en ce que**
l'âme de fil (2, 12, 22) est écrouie et/ou
l'âme de fil (22) est une bande, en particulier une bande revêtue.

11. Procédé de fabrication d'un fil sous gaine (1, 11, 21), en particulier d'un fil sous gaine (1, 11, 21) selon l'une quelconque des revendications précédentes, **caractérisé par** les étapes chronologiques suivantes
A) mise à disposition d'une âme de fil (2, 12, 22) en rhodium ou en un alliage à base de rhodium,
B) revêtement de l'âme de fil (2, 12, 22) avec une couche conférant de l'adhérence (5, 15, 25) en or ou en un alliage à base d'or,
C) revêtement de l'âme de fil (2, 12, 22) revêtue de la couche conférant de l'adhérence (5, 15, 25) avec une gaine intérieure (3, 13, 23) en cuivre ou argent ou aluminium ou en un alliage à base de cuivre ou un alliage à base d'argent ou un alliage à base d'aluminium et
D) revêtement de l'âme de fil (2, 12, 22) revêtue de la couche conférant de l'adhérence (5, 15, 25) et de la gaine intérieure (3, 13, 23) avec une gaine extérieure (4, 14, 24) en un métal ou en un alliage métallique avec une dureté supérieure au matériau de la gaine intérieure (3, 13, 23).

12. Procédé selon la revendication 11, **caractérisé en ce que**
l'âme de fil (22) est en forme de bande et une étape C1) est effectuée entre les étapes C) et D) :
C1) découpe de l'âme de fil (22) revêtue en forme de bande perpendiculairement à un axe longitudinal de la bande en une pluralité d'âme de fil (22) revêtues, dans lesquelles les âmes de fil (22) sont revêtues sur deux côtés opposés par la couche conférant de l'adhérence (25) et la gaine intérieure (23) et dans lequel
à l'étape D), chacune des âmes de fil (22) revêtues est revêtue avec la gaine extérieure (24).

13. Procédé selon la revendication 11 ou 12, **caractérisé en ce que** une étape C2) est effectuée entre les étapes C) et D) :
C2) revêtement de l'âme de fil (2, 12, 22) revêtue de la couche conférant de l'adhérence (5, 15, 25) et de la gaine intérieure (3, 13, 23) avec une couche antidiffusion, de préférence avec une couche antidiffusion en nickel ou en or ou en un alliage à base de nickel ou un alliage à base d'or et dans lequel, à l'étape D), le revêtement de l'âme de fil (2, 12, 22), revêtue de la couche conférant de l'adhérence (5, 15, 25), de la gaine intérieure (3, 13, 23) et de la couche antidiffusion, avec la gaine extérieure (4, 14, 24) est effectué.

14. Procédé selon l'une quelconque des revendications 11 à 13, **caractérisé en ce que** les revêtements selon les étapes B), C) et D) et le cas échéant C2) sont appliqués par un procédé galvanique et/ou par un procédé physique, en particulier par dépôt physique en phase vapeur (PVD).

15. Aiguille de test présentant au moins un fil sous gaine (1, 11, 21) selon l'une quelconque des revendications 1 à 10 ou fabriquée à partir d'un fil sous gaine (1, 11, 21), qui a été fabriqué au moyen d'un procédé selon l'une quelconque des revendications 11 à 14, l'aiguille de test étant de préférence coudée perpendiculairement à l'axe de cylindre du fil sous gaine (1, 11) ou perpendiculairement à un axe longitudinal du fil sous gaine (1, 11, 21).

16. Série d'aiguilles de test présentant plusieurs aiguilles de test selon la revendication 15 espacées les unes des autres.

17. Contact abrasif présentant plusieurs fils sous gaine (1, 11, 21) selon l'une quelconque des revendications 1 à 10 ou fabriqué à partir d'un fil sous gaine (1, 11, 21), qui a été fabriqué au moyen d'un procédé selon l'une quelconque des revendications 11 à 14, les fils sous gaine (1, 11, 21) formant de préférence un faisceau de fils.
